# EUROPÄISCHE PATENTSCHRIFT

(11) **EP 0 976 189 B1**
(45) Veröffentlichungstag und Bekanntmachung des Hinweises auf die Patenterteilung: **14.01.2004**
(21) Anmeldenummer: 98928158.9
(22) Anmeldetag: 16.04.1998
(51) Int. Cl.: H02H 1/00, G01R 31/08

(54) **VERFAHREN ZUR ERMITTLUNG DES ORTES EINER TEILENTLADUNG**
METHOD FOR DETERMINING THE LOCATION OF A PARTIAL DISCHARGE
PROCEDE POUR DETERMINER L'EMPLACEMENT D'UNE DECHARGE PARTIELLE

(30) Priorität: 16.04.1997 DE 19716963
(43) Veröffentlichungstag der Anmeldung: 02.02.2000
(73) Patentinhaber: SIEMENS AKTIENGESELLSCHAFT, 80333 München (DE)
(72) Erfinder: HÜCKER, Thomas Dr., D-14624 Dallgow-Döberitz (DE); GORABLENKOW, Jörg, D-13591 Berlin (DE)
(86) Internationale Anmeldenummer: PCT/DE1998/001092
(87) Internationale Veröffentlichungsnummer: WO 1998/047213

(56) Entgegenhaltungen:
- EP-A- 0 572 767
- US-A- 5 537 327
- PATENT ABSTRACTS OF JAPAN vol. 017, no. 076 (P-1487), 16. Februar 1993 & JP 04 279870 A (HITACHI CABLE LTD), 5. Oktober 1992

## Beschreibung

Die Erfindung bezieht sich auf ein Verfahren zur Ermittlung des Ortes eines Teilentladung in einer Hochspannungsanlage, bei dem durch eine Teilentladung erzeugte Signale erfaßt und einer Auswerteeinrichtung zugeführt werden.

Aus der Zusammenfassung des japanischen Patents JP 4 279 870 ist ein Verfahren zur Bestimmung des Ortes eines Fehlers bekannt geworden, das mehrere Sensoren und ein neuronales Netz einsetzt.

Ein Verfahren zur Untersuchung von Teilentladungen ist beispielsweise aus der EP 0 241 764 A1 bekannt. Dort ist beschrieben, daß Hochfrequenzmeßwerte von elektrischen Teilentladungen (TE) in einer Hochspannungsanlage durch mehrere Sensoren aufgenommen und mit bestimmten Werten verglichen werden, die ihrerseits durch Simulation von Teilentladungen in einem simulierten Netzwerk entstehen, welches bezüglich der Modellierung der vorliegenden Hochspannungsanlage in bezug auf das Hochfrequenzverhalten entspricht. Durch Vergleich der gemessenen mit den bei der Simulation erhaltenen Werten kann auf den Ort und die Art der Teilentladung geschlossen werden.

Zur Durchführung des beschriebenen Verfahrens ist eine genaue Analyse der vorliegenden Hochspannungsanlage in bezug auf das Hochfrequenzverhalten und die Übertragungseigenschaften notwendig. Dies erfordert für jede Anlage die Schaffung eines neuen Simulationsnetzwerkes. Der Arbeitsaufwand hierfür ist beträchtlich.

Aus dem Fachartikel "Artificial self-organizing neural network for partial discharge source recognition", Archiv für Elektrotechnik, 76 (1993) S. 149-154, ist ein Verfahren zur Untersuchung elektrischer Teilentladungen mit Hilfe eines vorher trainierten neuronalen Netzes bekannt. Das neuronale Netz wird vorher anhand wirklicher Teilentladungen, die mittels eines Sensors erfaßt werden, trainiert. Mittels dieses Verfahrens können zu auftretenden Teilentladungen entsprechende Ursachen ermittelt werden.

Die DE-PS 43 33 259 offenbart ein Verfahren zur Lokalisierung von elektrischen Störungen in Form von Kurzschlußströmen, das ebenfalls mit Hilfe eines neuronalen Netzes arbeitet, welches mit Meßdaten trainiert wird, welche durch einen einzelnen Sensor gewonnen werden. Ergebnis des dort beschriebenen Verfahrens ist eine Richtungsangabe, die sich darauf bezieht, in welcher Richtung ein Kurzschluß, von einer Erfassungsstelle aus gesehen, liegt.

Der vorliegenden Erfindung liegt demgegenüber die Aufgabe zugrunde, ein Verfahren zur Ermittlung des Ortes einer Teilentladung in einer Hochspannungsanlage zu schaffen, das einfach und mit geringem Aufwand und hoher Genauigkeit durchführbar ist und daß an verschiedene Gestaltungen der Hochspannungsanlage mit geringem Aufwand anpaßbar ist und dennoch individuell optimierte Ergebnisse liefert.

Die Aufgabe wird erfindungsgemäß dadurch gelöst, daß die Auswerteeinrichtung ein neuronales Netz aufweist, welches vorher durch Eingabe von Teilentladungsmeßdaten trainiert worden ist, wobei dem neuronalen Netz zum Training von wenigstens zwei Sensoren erfaßte Meßdaten unter gleichzeitiger Vorgabe der Entstehungsorte der entsprechenden Teilentladungen zugeführt werden und wobei der Auswerteeinrichtung zur Untersuchung einer Teilentladung ebenfalls Meßdaten der wenigstens zwei Sensoren zugeführt werden.

Durch die Verwendung eines neuronalen Netzes zur Auswertung muß die Hochspannungsanlage nicht mehr auf ihr Hochfrequenzverhalten hin analysiert werden. Es muß nicht, wie beim Stand der Technik oft üblich, für einzelne Elemente der Hochspannungsanlage ein Transmissionskoeffizient, ein Dämpfungskoeffizient und ein Reflexionskoeffizient bestimmt werden. Somit ist die Anpassung der Auswerteeinrichtung, d. h. das Trainieren des neuronalen Netzes mit deutlich geringerem Aufwand für jede aufzubauende Schaltanlage möglich als die entsprechende Analyse der Hochspannungsanlage und die Erstellung einer Netzwerksimulation.

Die Genauigkeit und Zuverlässigkeit der Ergebnisermittlung durch das neuronale Netz ist hauptsächlich von der Anzahl und räumlichen Verteilung der Sensoren, der Qualität des Trainings und von der Anzahl der Trainingsmessungen abhängig. Hierfür können Standards festgesetzt werden, so daß das erfindungsgemäße Verfahren auch durch nichtqualifiziertes Personal durchführbar ist.

Durch den Einsatz von mindestens zwei Sensoren wird die Lokalisierung erheblich vereinfacht und im Ergebnis genauer. Die analysierbare Datenbasis wird nicht nur durch die Anzahl der verfügbaren Daten, sondern auch durch die unterschiedliche Perspektive verschiedener Sensoren bezüglich des zu ermittelnden Ortes der Teilentladung wesentlich verbessert.

Das Training des neuronalen Netzes kann auch beinhalten, solche Störsingale, die von echten Teilentladungen in der Hochspannungsanlage herrühren, von solchen Ereignisse zu unterscheiden, die entweder regelmäßige Vorkommnisse (Betätigung von Schaltern) oder von außen eingestrahlte Störungen repräsentieren.

Eine vorteilhafte Ausgestaltung der Erfindung sieht vor, daß die Meßdaten vor der Eingabe in das neuronale Netz in einer Verarbeitungseinrichtung vorverarbeitet werden, welche einen Teil der Auswerteeinrichtung bildet.

Hierdurch können die Meßdaten so vorbereitet werden, daß sie eine hohe Signifikanz in bezug auf die Lokalisierung von Teilentladungen aufweisen und daß somit das Ergebnis nach dem Durchlaufen des neuronalen Netzes noch zuverlässiger und genauer wird.

Eine weitere vorteilhafte Ausgestaltung der Erfindung sieht vor, daß mehr als zwei Sensoren vorgesehen sind, wobei nur die Meßdaten der zwei Sensoren der Auswerteeinrichtung zugeleitet werden, bei denen sich die größte Signalstärke der Teilentladungssignale ergibt.

Durch eine solche Auswahl der der Auswerteeinrichtung zugeleiteten Meßdaten wird ebenfalls eine bessere Zuverlässigkeit bei der Verarbeitung durch das neuronale Netz erreicht.

Die Erfindung kann außerdem vorteilhaft dadurch ausgestaltet werden, daß die Meßdaten in der Verarbeitungseinrichtung bezüglich der Frequenz analysiert werden.

Hierdurch werden Signale, die nicht von echten Teilentladungen herrühren, bei der Analyse unberücksichtigt gelassen, da wirkliche Teilentladungsvorgänge eine hohe Korrelation mit der Netzfrequenz aufweisen.

Es ist auch möglich, die Erfindung vorteilhaft dadurch zu gestalten, daß die Korrelation der Meßdaten mit der Netzfrequenz oder ganzzahligen Vielfachen hiervon bestimmt wird und daß nur solche Meßdaten, deren Korrelationswert einen bestimmten Wert überschreitet, dem neuronalen Netz zugeführt werden.

Schon beim Training des neuronales Netzes müssen diesem dann entsprechend vorverarbeitete Signale geliefert werden.

Ebenso ist es möglich, die Erfindung dadurch auszugestalten, daß bestimmten Phasenlagen der Teilentladungssignale zur Nutzfrequenz und bestimmten Signalstärken jeweils die Häufigkeit zugeordnet wird, mit der diese Werte bei einer Teilentladungsmessung auftreten und daß diese Häufigkeitswerte dem neuronalen Netz zugeführt werden.

Eine weitere vorteilhafte Ausgestaltung der Erfindung sieht vor, daß der Impulsverlauf eines Teilentladungssignals im Zeitbereich erfaßt und dem neuronalen Netz zugeführt wird.

Auch in diesem Fall muß das neuronale Netz mit entsprechend vorverarbeiteten Signalen trainiert werden.

Im folgenden wird die Erfindung anhand eines Ausführungsbeispiels in einer Zeichnung gezeigt und nachfolgend beschrieben.

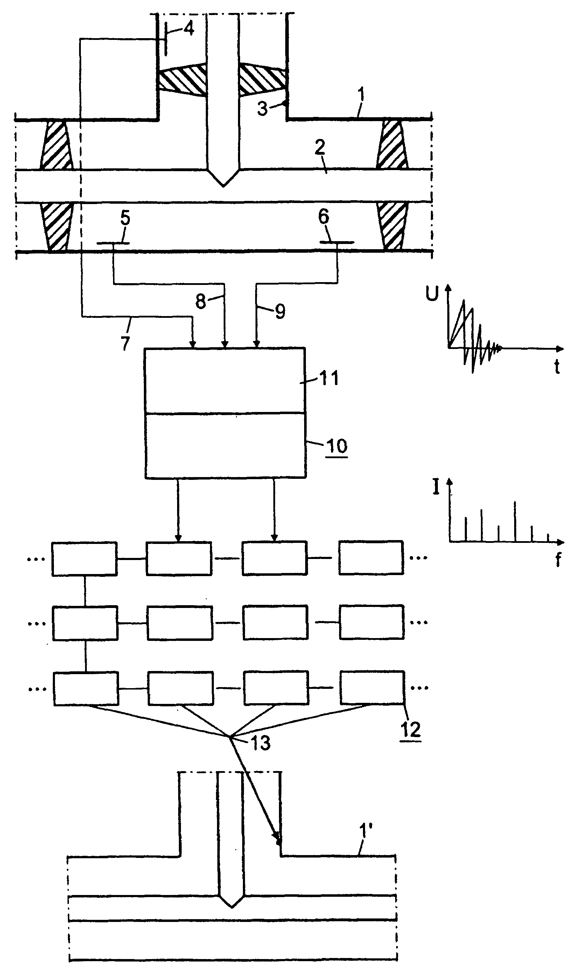

Dabei zeigt die Figur schematisch eine Hochspannungsanlage mit Teilentladungsmeßeinrichtungen und ein neuronales Netz.

In der Figur ist schematisch ausschnittsweise ein Kapselungsgehäuse 1 einer Hochspannungsanlage dargestellt, das aus Metall besteht und einen Hochspannungsleiter 2 gasdicht umgibt. Im Normalfall ist das Kapselungsgehäuse 1 mit einem Isoliergas, beispielsweise SF₆ unter hohem Druck gefüllt.

In der Darstellung ist ein T-Stück gezeigt, an dem sich der Hochspannungsleiter 2 verzweigt. Mit 3 ist eine Unregelmäßigkeit, beispielsweise eine freie Partikel oder eine Unregelmäßigkeit an der Oberfläche der Metallkapselung 1 bezeichnet, die das Entstehen von Teilentladungen initiieren bzw. begünstigen kann. Solche Teilentladungen erzeugen elektromagnetische Wellen, die sich in verschiedenen Moden innerhalb des Kapselungsgehäuses 1 ausbreiten. Die Signale können durch Meßsonden 4, 5, 6 erfaßt werden, die jeweils eine gegenüber dem Kapselungsgehäuse 1 isolierte Elektrode aufweisen, die mit je einer Meßleitung 7, 8, 9 verbunden ist, durch welche die Meßdaten der Auswerteeinrichtung 10 zugeführt werden können.

Als besonders vorteilhaft erweist sich die Erfassung von Moden, deren Frequenz oberhalb der Frequenz der T-E-M-Mode liegt, d. h. typischerweise im Bereich oberhalb von ca. 400 MHz.

In der Auswerteeinrichtung 10 ist eine Verarbeitungseinrichtung 11 vorgesehen, in der die Meßdaten vorverarbeitet werden. Es werden jeweils nur die Meßdaten derjenigen zwei Sensoren ausgewertet, die die größten Signalstärken liefern.

In der Auswerteeinrichtung werden die Meßdaten einer Fourieranalyse unterworfen und es wird die Korrelation zu der Netzfrequenz (50 Hz) des in der Hochspannungsanlage zu verteilenden Wechselstroms gemessen. Diejenigen Signale, die eine über einem bestimmten Schwellwert liegende Korrelation mit der Nutzfrequenz (= Netzfrequenz) haben, werden als echte TE-Signale identifiziert, die von einer innerhalb der Hochspannungsanlage befindlichen TE-Quelle herrühren, da nur solche Signale in hohem Maße vom Verlauf der Nutzspannung abhängig sind.

Diese Signale werden einem neuronalen Netz 12 zugeführt, das vorher anhand einer Anzahl von Teilentladungen, deren Entstehungsort bekannt ist, trainiert worden ist.

Am Ausgang 13 des neuronalen Netzes ergibt sich ein Signal, das über den Ort der aktuellen Teilentladung in einer Darstellung 1' des Kopplungsgehäuses 1 Auskunft gibt.

Das Training des neuronalen Netzes 12 wird folgendermaßen durchgeführt:
Es wird gezielt nacheinander eine gewisse Anzahl von Teilentladungen in der Hochspannungsanlage erzeugt und dem neuronalen Netz wird als auszugebendes Signal am Ausgang 13 der wahre Ort der jeweils vorliegenden Teilentladung vorgegeben. Innerhalb des neuronalen Netzes werden bei den Kopplungsstellen zwischen den einzelnen Neuronen (Synapsen) bestimmte Kopplungsgewichte so verschoben, daß jeweils für einen Trainingsfall das vorgegebene Ergebnis reproduziert wird. Nach einer gewissen Anzahl von Trainingsdurchgängen ergibt sich bei entsprechender Signaleingabe in das neuronale Netz mit hoher Wahrscheinlichkeit als Ausgabe der richtige Wert für die Lokalisation einer Teilentladung.

Die Erfindung ist vorteilhaft bei komplexen Hochspannungsschaltanlagen mit vielen Abzweigungen, jedoch auch bei Rohrgasleitern mit wenigen Abzweigungen einsetzbar.

## Patentansprüche

1. Verfahren zur Ermittlung des Ortes einer Teilentladung in einer Hochspannungsanlage, bei dem durch eine Teilentladung erzeugte Signale erfaßt und
einer Auswerteeinrichtung (10) zugeführt werden, die ein neuronales Netz (12) aufweist, welches vorher durch Eingabe von Teilentladungsmeßdaten trainiert worden ist,
wobei dem neuronalen Netz (12) zum Training von wenigstens zwei Sensoren (4,5,6) erfaßte Meßdaten unter gleichzeitiger Vorgabe der Entstehungsorte der entsprechenden Teilentladungen zugeführt werden und wobei der Auswerteeinrichtung zur Untersuchung einer Teilentladung ebenfalls Meßdaten der wenigstens zwei Sensoren zugeführt werden.

2. Verfahren nach Anspruch 1,
**dadurch gekennzeichnet, daß**
die Meßdaten vor der Eingabe in das neuronale Netz in einer Verarbeitungseinrichtung (11) vorverarbeitet werden, welche einen Teil der Auswerteeinrichtung (10) bildet.

3. Verfahren nach Anspruch 1 oder 2,
**dadurch gekennzeichnet, daß**
mehr als zwei Sensoren (4, 5, 6) vorgesehen sind, wobei nur die Meßdaten der zwei Sensoren der Auswerteeinrichtung (10) zugeleitet werden, bei denen sich die größte Signalstärke der Teilentladungssignale ergibt.

4. Verfahren nach Anspruch 2 oder einem der folgenden,
**dadurch gekennzeichnet, daß**
die Meßdaten in der Verarbeitungseinrichtung (10) bezüglich der Frequenz analysiert werden.

5. Verfahren nach Anspruch 4,
**dadurch gekennzeichnet, daß**
die Korrelation der Meßdaten mit der Netzfrequenz oder ganzzahligen Vielfachen hiervon bestimmt wird und daß nur solche Meßdaten, deren Korrelationswert einen bestimmten Wert überschreitet, dem neuronalen Netz (12) zugeführt werden.

6. Verfahren nach Anspruch 2,
**dadurch gekennzeichnet, daß** bestimmten Phasenlagen der Teilentladungssignale zur Netzfrequenz und bestimmten Signalstärken jeweils die Häufigkeit zugeordnet wird, mit der diese Werte bei einer Teilentladungsmessung auftreten und daß diese Häufigkeitswerte dem neuronalen Netz (12) zugeführt werden.

7. Verfahren nach Anspruch 2,
**dadurch gekennzeichnet, daß**
der Impulsverlauf eines Teilentladungssignals im Zeitbereich erfaßt und dem neuronalen Netz (12) zugeführt wird.

## Claims

1. Method for determining the location of a partial discharge in a high-voltage system in which signals produced by a partial discharge are detected and supplied to an evaluation device (10) which has a neural network (12) which has been trained in advance by partial discharge measurement data being input,
in which, for training purposes, measurement data detected by at least two sensors (4, 5, 6) are supplied to the neural network (12), indicating at the same time the points of origin of the corresponding partial discharges, and in which measurement data from the at least two sensors are likewise supplied to the evaluation device for the purpose of investigating a partial discharge.

2. Method according to Claim 1,
**characterized in that**,
prior to being input in the neural network, the measurement data are preprocessed in a processing device (11) which forms part of the evaluation device (10).

3. Method according to Claim 1 or 2,
**characterized in that**
more than two sensors (4, 5, 6) are provided, in which only the measurement data from the two sensors producing the partial discharge signals having the greatest signal intensity are fed to the evaluation device (10).

4. Method according to Claim 2 or one of the following claims,
**characterized in that**
the measurement data are analysed with respect to their frequency in the processing device (10).

5. Method according to Claim 4,
**characterized in that**
the correlation of the measurement data with the system frequency or integral multiples thereof is determined, and **in that** only those measurement data whose correlation value exceeds a specific value are supplied to the neural network (12).

6. Method according to Claim 2,
**characterized in that**
specific phase angles of the partial discharge signals with respect to the system frequency and specific signal intensities are in each case associated with the probability with which these values occur during a partial discharge measurement, and **in that** these probability values are supplied to the neural network (12).

7. Method according to Claim 2,
**characterized in that**
the pulse characteristic of a partial discharge signal is detected in the time waveform domain and is supplied to the neural network (12).

## Revendications

1. Procédé de détermination de l'emplacement d'une décharge partielle d'une installation à haute tension,
dans lequel on détecte des signaux produits par une décharge partielle et on les envoie à un dispositif d'évaluation (10) qui comporte un réseau neuronal (12) qui a subi préalablement un apprentissage par l'entrée de données mesurées de décharges partielles,
dans lequel, pour son apprentissage, on envoie au réseau neuronal (12) des données mesurées par au moins deux capteurs (4, 5, 6) en même temps qu'on lui prescrit les emplacements de formation des décharges partielles correspondantes
et dans lequel, pour l'analyse d'une décharge partielle, on envoie également au dispositif d'évaluation des données mesurées des deux ou plus capteurs.

2. Procédé selon la revendication 1,
**caractérisé par le fait que**, avant leur entrée dans le réseau neuronal, on prépare les données mesurées dans un dispositif de traitement (11) qui fait partie du dispositif d'évaluation (10).

3. Procédé selon la revendication 1 ou 2,
**caractérisé par le fait qu'**il est prévu plus de deux capteurs (4, 5, 6) et qu'on envoie au dispositif d'évaluation (10) seulement les données mesurées des deux capteurs pour lesquels on a la plus grande intensité des signaux de décharge partielle.

4. Procédé selon la revendication 2 ou l'une des revendications suivantes,
**caractérisé par le fait qu'**on analyse les données mesurées dans le dispositif de traitement (1) en ce qui concerne la fréquence.

5. Procédé selon la revendication 4,
**caractérisé par le fait qu'**on détermine la corrélation des données mesurées avec la fréquence de réseau ou avec des multiples entiers de celle-ci et qu'on envoie au réseau neuronal (12) seulement des données mesurées dont la valeur de corrélation dépasse une certaine valeur.

6. Procédé selon la revendication 2,
**caractérisé par le fait qu'**on associe à certaines relations de phase des signaux de décharge partielle vis-à-vis de la fréquence de réseau et à certaines intensités de signal à chaque fois la fréquence avec laquelle ces valeurs apparaissent lors d'une mesure de décharge partielle et qu'on envoie ces valeurs de fréquence au réseau neuronal (12).

7. Procédé selon la revendication 2,
**caractérisé par le fait qu'**on détecte l'allure des impulsions d'un signal de décharge partielle dans le domaine temporel et qu'on l'envoie au réseau neuronal (12).
